# EUROPEAN PATENT APPLICATION

(11) **EP 4 712 304 A1**
(43) Date of publication of application: **18.03.2026**
(21) Application number: 25201425.3
(22) Date of filing: 10.09.2025
(51) Int. Cl.: H02J 7/40, H02J 7/50

(54) **SYSTEM AND METHOD FOR CHECKING A NUMBER OF MODULES**

(30) Priority: 12.09.2024 KR 20240125146
(71) Applicant: SAMSUNG SDI CO., LTD., Yongin-si, Gyeonggi-do 17084 (KR)
(72) Inventor: YOO, Jae Shik, 17084 Yongin-si (KR); SEO, Youngdong, 17084 Yongin-si (KR)
(74) Representative: Maiwald GmbH

(57) **Abstract**

Disclosed is a system and a method for checking the number of a plurality of cell modules connected to a battery management system (BMS). The system for checking the number of modules includes a message management unit that generates special messages to be transmitted to a first cell module among a plurality of cell modules connected in series or in parallel, and receives special messages received from an nth cell module, and a failure mode operation determination unit that receives information on whether the special messages are received from the message management unit and information on the special messages received from the nth cell module, and determines an entry to a failure mode.

## Description

### BACKGROUND

### 1. Technical Field

Aspects of some embodiments of the present disclosure relate to a system and a method for checking a number of modules, and to a system and a method for checking a number of a plurality of cell modules connected to a battery management system (BMS).

### 2. Related Art

In the case of a battery pack used by connecting a plurality of cell modules to a BMS, there is a problem of a human error occurring due to erroneous hardware operation by an operator during an installation process for setting the number of cell modules.

The related art has a problem in that a cell module operation is performed differently from an actual capacity when performing hardware setting in which a smaller number than the number of modules actually connected in parallel is set, and has a problem in that when the number of modules connected in series is erroneously set, a failure mode occurs due to erroneous pack voltage setting.

### SUMMARY

An object of the present disclosure is to provide a system and a method for automatically checking the number of cell modules, which can prevent a human error by automatically recognizing the number of modules connected to a BMS in a software manner.

A system for checking the number of modules according to the present disclosure includes: a message management unit that generates special messages to be transmitted to a first cell module among a plurality of cell modules connected in series or in parallel, and receives special messages received from an n^{th} cell module; and a failure mode operation determination unit that receives information on whether the special messages are received from the message management unit and information on the special messages received from the n^{th} cell module, and determines an entry to a failure mode.

The message management unit considers a maximum number of cell modules connectable to a battery pack, generates special messages that are one more than the maximum number of cell modules, and transmits the generated special messages to the first cell module.

The special message received from the n^{th} cell module includes a result of transmitting remaining messages except for a last message among messages respectively received by the plurality of cell modules connected in series or in parallel.

The failure mode operation determination unit includes a timeout check section, and when no message is received by the message management unit within a timeout period, a timeout check section determines whether to finally operate in the failure mode through a retry process.

The failure mode operation determination unit includes a packet error code check section, and the packet error code check section checks a packet error code of the received special message, and determines an entry to the failure mode when it is determined that there is an error as a result of checking the packet error code.

The failure mode operation determination unit includes a protocol check section, and the protocol check section checks STX and ETX protocols included in the special message, and determines an entry to the failure mode when it is determined that there is an error.

The failure mode operation determination unit includes a number-of-cell modules check section, and the number-of-cell modules check section checks whether cell module number data has been sequentially received to check whether a cell module number has been received in duplicate or missing, and determines an entry to the failure mode when it is determined that there is an error.

A method for checking the number of modules according to the present disclosure includes: (a) generating special messages for checking data integrity; (b) determining whether a cell module transmission result is received; and (c) determining an entry to a failure mode by analyzing the received special messages and automatically recognizing the number of cell modules.

In (a), a special message to be transmitted from a BMS to a cell module is generated, and more special messages than a maximum number of cell modules by a preset number 1 are generated in consideration of a maximum number of cell modules connectable to a battery pack.

The special message includes a packet error code, and each message includes STX and ETX protocols and data in which a cell module number is sequentially increased from 1.

In (b), it is checked whether special messages to be transmitted to the cell modules are received through a plurality of cell modules connected in series or in parallel.

In (c), it is determined whether to enter the failure mode, by using at least one of whether the special messages have been received and a result of analyzing the special messages.

In (c), when there is no error, the number of cell modules is automatically recognized and a main loop operation is performed.

In (c), when it is checked that no message is received within a timeout period, whether to finally operate in the failure mode is determined through a retry process.

In (c), a packet error code of the received special message is checked, and when it is determined that there is an error as a result of checking the packet error code, the system operates in the failure mode.

In (c), when it is determined that there is an error by checking STX and ETX protocols, the system operates in the failure mode.

In (c), the number of connected cell modules is checked by analyzing the received messages, whether cell module number data has been sequentially received is checked to check whether a cell module number has been received in duplicate or missing, and when it is determined that there is an error, the system operates in the failure mode.

An apparatus for checking the number of modules, the apparatus includes: an input interface device that receives special messages received from cell modules; a memory that stores a program for automatically recognizing the number of cell modules by analyzing the special messages; and a processor that executes the program, wherein the processor determines whether to enter a failure mode by using at least one of whether the special messages are received within a preset time and a result of analyzing information of the special messages.

The processor determines whether to enter the failure mode when no special messages are received within the preset time, and when the special messages are received, the processor determines whether to enter the failure mode by using the result of analyzing information of the special messages to check a packet error code, check STX and ETX protocols, and check whether a cell module number has been received in duplicate or missing.

The present disclosure has an effect capable of improving the reliability of cell module operation and pack voltage settings by preventing a human error from occurring due to hardware settings for the number of cell modules and automatically recognizing the number of cell modules in a software manner.

### BRIEF DESCRIPTION OF THE DRAWINGS

The following drawings illustrate example embodiments of the present disclosure, and further describe example aspects of the present disclosure together with the detailed description of the present disclosure. Thus, the present disclosure should not be construed as being limited to the drawings:
FIG. 1 schematically illustrates an electrode assembly of a secondary battery;
FIG. 2 schematically illustrates a configuration of a pouch-type secondary battery;
FIG. 3 illustrates a schematic external appearance configuration of a prismatic secondary battery;
FIG. 4 is a cross-sectional view of a cylindrical secondary battery;
FIG. 5 illustrates a system for checking the number of modules according to an embodiment of the present disclosure;
FIG. 6 illustrates a communication hardware configuration of a BMS and a cell module of the system for checking the number of modules according to an embodiment of the present disclosure;
FIG. 7 illustrates a special message transmission and reception process for automatically recognizing of the number of cell modules according to an embodiment of the present disclosure;
FIGS. 8, 9, and 10 illustrate a method for checking the number of modules according to an embodiment of the present disclosure;
FIG. 11 is a block diagram illustrating a computer system for implementing the method according to an embodiment of the present disclosure;
FIG. 12 is an example view of a secondary battery module in which secondary batteries manufactured according to examples of the present disclosure are arranged;
FIG. 13 is an example view of a secondary battery pack including the secondary battery module illustrated in FIG. 12; and
FIG. 14 is a conceptual view of a vehicle including the secondary battery pack illustrated in FIG. 13.

### DETAILED DESCRIPTION

Hereinafter, example embodiments of the present disclosure will be described, in detail, with reference to the accompanying drawings. The terms or words used in the present specification and claims are not to be limitedly interpreted based on their general or ordinary meaning, and should be interpreted as meanings and concepts that are consistent with the technical idea of the present disclosure on the basis of the principle that an inventor can be their own lexicographer to appropriately define concepts of terms to describe their invention in the best way.

The example embodiments described in this specification and the configurations shown in the drawings are only some example embodiments of the present disclosure and do not represent all of the aspects of the present disclosure. Accordingly, it should be understood that there may be various equivalents and modifications that can replace or modify one or more example embodiments described herein at the time of filing this application.

It will be understood that if an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, if a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" if describing embodiments of the present disclosure relates to "one or more embodiments of the present disclosure." Expressions, such as "at least one of" and "any one of," if preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," if used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges is within the scope of this invention.

References to two compared elements, features, etc. As being "the same" may mean that they are "substantially the same." Thus, the phrase "substantially the same" may include a case having a deviation that is considered low in the art, for example, a deviation of 5% or less. In addition, if a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may contact the upper (or lower) surface of the element, and another element may also be interposed between the element and the arbitrary element located on (or under) the element.

In addition, it will be understood that if a component is referred to as being "linked," "coupled," or "connected" to another component, the elements may be directly "coupled," "linked" or "connected" to each other, or another component may be "interposed" between the components."

Throughout the specification, if "A and/or B" is stated, it means A, B or A and B, unless otherwise stated. That is, "and/or" includes any or all combinations of a plurality of items enumerated. When "C to D" is stated, it means C or more and D or less, unless otherwise specified.

When the terms "about" or "substantially" are used in this specification in connection with a numerical value, it is intended that the associated numerical value include a tolerance of ±10% around the stated numerical value. When ranges are specified, the range includes all values therebetween such as increments of 0.1%.

The terminology used herein is for the purpose of describing example embodiments of the present disclosure and is not intended to limit the present disclosure.

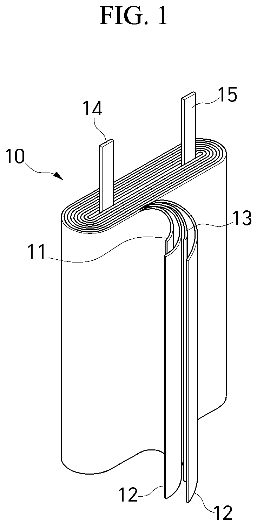

FIG. 1 schematically illustrates an electrode assembly built in a case of a secondary battery.

An electrode assembly 10 may be formed by winding or stacking a stack of a first electrode plate 11, a separator 12, and a second electrode plate 13, which are formed as thin plates or films. When the electrode assembly 10 is a wound type, a winding axis may be parallel to the longitudinal direction of the case 59. In other example embodiments, the electrode assembly 10 may be a stack type rather than a winding type, and the shape of the electrode assembly 10 is not limited in the examples of the present disclosure. In addition, the electrode assembly 10 may be or include a Z-stack electrode assembly in which a positive electrode plate and a negative electrode plate are inserted into both sides of a separator, which is then bent into a Z-stack. In addition, one or more electrode assemblies may be stacked such that long sides of the electrode assemblies are adjacent to each other and accommodated in the case, and the number of electrode assemblies in the case is not limited in the examples of the present disclosure. The first electrode plate 11 of the electrode assembly may act as a negative electrode, and the second electrode plate 13 may act as a positive electrode. In examples, the reverse is also possible.

The first electrode plate 11 may be formed by applying a first electrode active material, such as graphite or carbon, to a first electrode current collector formed of a metal foil, such as copper, a copper alloy, nickel, or a nickel alloy. The first electrode tab 14 may be connected to an external first terminal (not shown). In some example embodiments, when the first electrode plate 11 is manufactured, the first electrode tab 14 may be formed by being cut in advance to protrude to one side of the electrode assembly 10, or the first electrode tab 14 may protrude to one side of the electrode assembly 10 more than, e.g., farther than or beyond, the separator 12 without being separately cut.

The second electrode plate 13 may be formed by applying a second electrode active material, such as a transition metal oxide, on a second electrode current collector formed of or including a metal foil, such as aluminum or an aluminum alloy. The second electrode plate 13 may include a second electrode tab 15 (e.g., a second uncoated portion) that is or includes a region to which the second electrode active material is not applied. The second electrode tab 15 may be connected to an external second terminal (not shown). In some example embodiments, the second electrode tab 15 may be formed by being cut in advance to protrude to the other side (e.g., the opposite side) of the electrode assembly 10 when the second electrode plate 13 is manufactured, or the second electrode plate 13 may protrude to the other side of the electrode assembly more than, e.g., farther than or beyond, the separator 12 without being separately cut.

In some example embodiments, the first electrode tab 14 may be located on the left side of the electrode assembly 10, and the second electrode tab 15 may be located on the right side of the electrode assembly 10. In other example embodiments, the first electrode tab 14 and the second electrode tab 15 may be located on one side of the electrode assembly 10 in the same direction.

Here, for convenience of description, the left and right sides are defined according to the electrode assembly 10 as oriented in FIG. 1, and the positions thereof may change when the secondary battery is rotated left and right or up and down.

The separator 12 hinders or substantially prevents a short-circuit between the first electrode 11 and the second electrode 13 while allowing movement of lithium ions therebetween. The separator 12 may be made of or include, for example, a polyethylene film, a polypropylene film, a polyethylene-polypropylene film, etc.

In some example embodiments, the electrode assembly 10 may be accommodated in the case (not shown) along with an electrolyte. In the case of a pouch-type secondary battery, an electrode assembly 10 may be accommodated in a pouch made of or including flexible material in the form illustrated in FIG. 1. In the case of a prismatic secondary battery, an electrode assembly 10 may be accommodated in a prismatic metal casing in the form illustrated in FIG. 1.

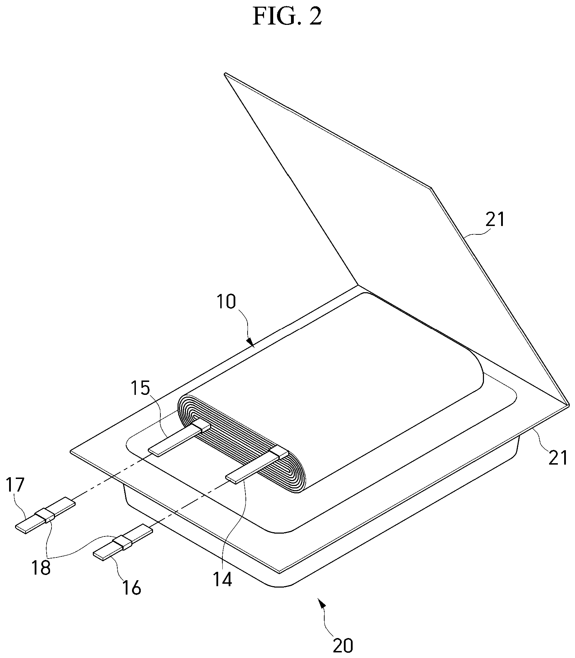

FIG. 2 schematically illustrates the pouch-type secondary battery.

The pouch-type secondary battery includes an electrode assembly 10 and a pouch 20 that accommodates or contains the electrode assembly 10 therein.

The electrode assembly 10 may be the same as the electrode assembly 10 illustrated in FIG. 1. The first electrode tab 14 and the second electrode tab 15 of the electrode assembly 10 may be electrically connected to respective external first and second terminal leads 16 and 17 by ,e.g., welding or other attaching method that preserves conductivity therebetween. At least a portion of each of the first terminal lead 16 and the second terminal lead 17 may be attached or covered with a tab film 18 for insulation from the pouch 20.

The pouch 20 may be sealed by having sealing parts 21 at the edges thereof come into contact with each other while accommodating or containing the electrode assembly 10 therein, in which case the sealing may be achieved with the tab film 18 interposed between the sealing parts 21. The sealing parts 21 of the pouch 20 may be made of or include a thermal fusion material that generally has weak adhesion to metal. Thus, it may be fused to the pouch 20 by interposing the thin tab film 18 between the sealing parts 21.

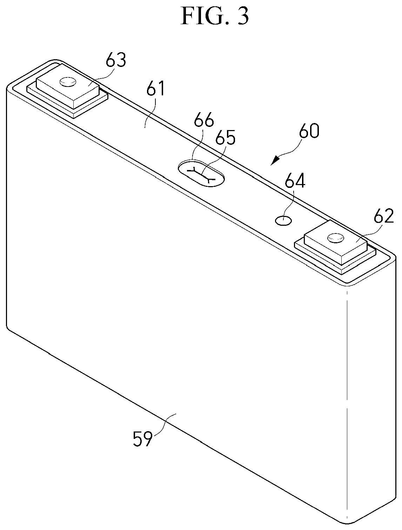

FIG. 3 illustrates a schematic external appearance configuration of a prismatic secondary battery.

A prismatic case 59 defines an overall appearance of the prismatic secondary battery, and may be made of or include a conductive metal, such as aluminum, aluminum alloy, or nickel-plated steel. In addition, the case 59 may provide a space for accommodating or containing the electrode assembly 10 therein.

A cap assembly 60 may include a cap plate 61 that covers an opening of the case 59, and the case 59 and the cap plate 61 may be made of or include a conductive material. A first terminal 63 and a second terminal 62 may be electrically connected to the first electrode tab 14 and the second electrode tab 15 of the electrode assembly 10 illustrated in FIGS. 1 and 2 inside the case 59, and may be installed to protrude outward through the cap plate 61.

The cap plate 61 may be equipped with or include an electrolyte injection port 64 configured to install a sealing plug therein, and a vent 66 formed that includes a notch 65 may be installed. The vent 66 is configured to discharge any gas generated inside the secondary battery.

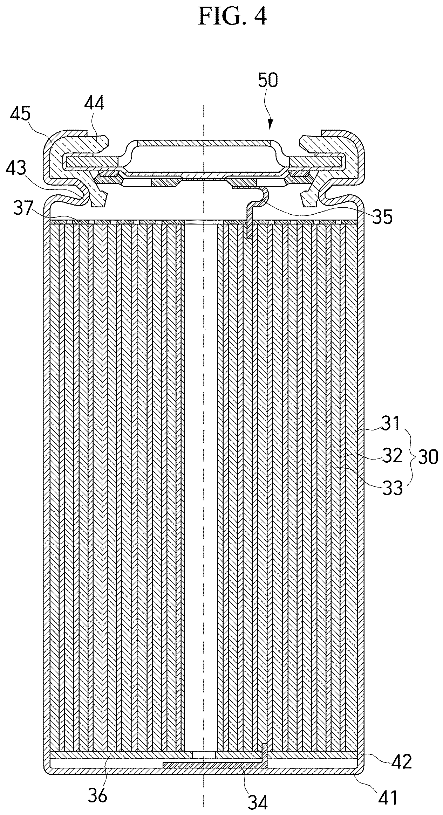

FIG. 4 is a cross-sectional view of a cylindrical secondary battery.

The cylindrical secondary battery includes an electrode assembly 30, a case accommodating the electrode assembly 30 and an electrolyte therein, a cap assembly 50 coupled to an opening of the case to seal the case, and an insulating plate 37 located between the electrode assembly 30 and the cap assembly 50 inside the case.

The electrode assembly 30 may include a separator 32 between a first electrode 33 and a second electrode 31, and the electrode assembly 30 may be wound in a jelly-roll form.

The first electrode 33 may include a first substrate and a first active material layer located on the first substrate. A first lead tab 35 may extend outward from a first uncoated portion of the first substrate where the first active material layer is not located, and may be electrically connected to the cap assembly 50.

The second electrode 31 may include a second substrate and a second active material layer located on the second substrate. A second lead tab 34 may extend outward from a second uncoated portion of the second substrate where the second active material layer is not located, and may be electrically connected to the case. The first lead tab 35 and the second lead tab 34 may extend in opposite directions with respect to each other.

The first electrode 33 may constitute a positive electrode. In this case, the first substrate may be composed of or include, for example, aluminum foil, and the first active material layer may include, for example, a transition metal oxide. The second electrode 31 may constitute a negative electrode. In this case, the second substrate may be composed of or include, for example, copper foil or nickel foil, and the second active material layer may include, for example, graphite.

The separator 32 may reduce or prevent a short-circuit between the first electrode 33 and the second electrode 31 while allowing movement of lithium ions therebetween. The separator 32 may be made of or include, for example, at least one of a polyethylene film, a polypropylene film, a polyethylene-polypropylene film, etc.

The case accommodates or contains the electrode assembly 30 and the electrolyte, and substantially forms the external appearance of the secondary battery together with the cap assembly 50. The case may have a substantially cylindrical body portion 42, and a bottom portion 41 connected to one side of the body portion 42. A beading part 43 deformed inwardly may be formed in the body portion 42, and a crimping part 45 bent inwardly may be formed at an open end of the body portion 42.

The beading part 43 may reduce or prevent movement of the electrode assembly 30 inside the case, and may facilitate seating of a gasket 44 and the cap assembly 50. A crimping part 45 may firmly fix the cap assembly 50 by pressing the edge of the cap assembly 50 against the gasket 44. The case may be formed of or include iron plated with nickel, for example.

The cap assembly 50 may be fixed to the inside of the crimping part 45 through the gasket 44 to seal the case. The cap assembly 50 may include a cap up, a safety vent, a cap down, an insulating member, and a subplate, but is not limited to this example and may be variously modified.

The cap up may be located at the very top of the cap assembly 50. The cap up may include a terminal portion that protrudes convexly upward and is connected to an external circuit, and an outlet for discharging gas may be located around the terminal portion.

The safety vent may be located below the cap up. The safety vent may include a protrusion that protrudes convexly downward and is connected to the subplate, and at least one notch located around the protrusion.

When gas is generated due to overcharging or abnormal operation of the secondary battery, the protrusion may be deformed upward by pressure and may separate from the subplate, while the safety vent may be cut along the notch. The cut safety vent may hinder or prevent the secondary battery from exploding by discharging gas to the outside.

The cap down may be located below the safety vent. The cap down may be formed with a first opening for exposing the protrusion of the safety vent and a second opening for discharging gas. The insulating member may be located between the safety vent and the cap down to insulate the safety vent and the cap down.

The subplate may be located below the cap down. The subplate may be fixed to a lower surface of the cap down to block the first opening of the cap down, and the protrusion of the safety vent may be fixed to the subplate. The first lead tab 35 pulled out from the electrode assembly 30 may be fixed to the subplate. Accordingly, the cap up, the safety vent, the cap down, and the subplate may be electrically connected to the first electrode 33 of the electrode assembly 30.

The insulating plate 37 may be located below the beading part 43 to be in contact with the electrode assembly 30, and may be provided with a tab opening for pulling out the first lead tab 35. The cap assembly 50, which is electrically connected to the first electrode 33 by the first lead tab 35, may face the electrode assembly 30 with the insulating plate 37 interposed therebetween, and may maintain an insulated state from the electrode assembly 30 by the insulating plate 37. On the other hand, another insulating plate 36 may be included for insulation between the electrode assembly 30 and the bottom portion 41 of the case.

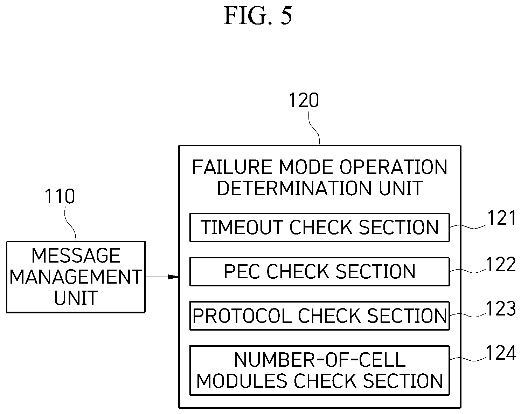

Hereinafter, a system and method for checking the number of modules according to an embodiment of the present disclosure is described with reference to FIGS. 5 to 11.

FIG. 5 illustrates a system for checking the number of modules according to an embodiment of the present disclosure.

A message management unit 110 according to an embodiment of the present disclosure generates special messages transmitted to cell modules, and transmits information on special messages received from the cell modules and whether the special messages are received to a failure mode operation determination unit 120.

The message management unit 110 considers the maximum number of cell modules connectable to a battery pack, generates special messages that are one more than the maximum number of cell modules, and transmits the generated special messages to the cell modules.

The cell modules transmit remaining messages, except for the last message, among the received special messages to next cell modules connected in serial or in parallel or a BMS.

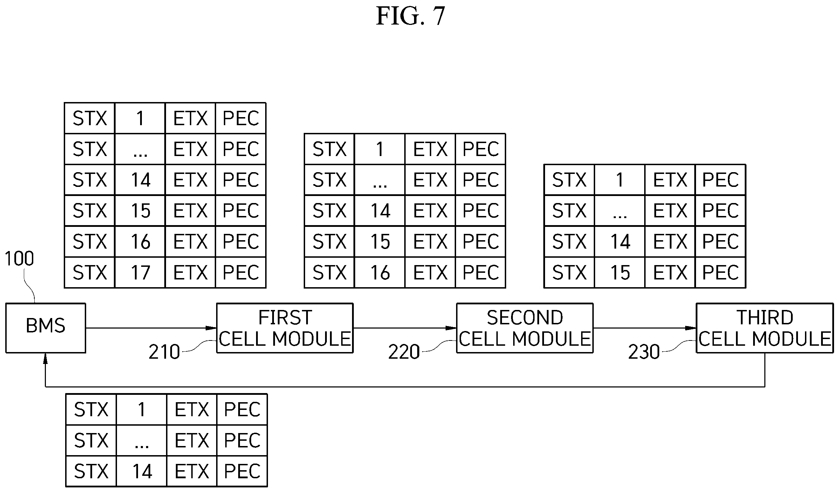

The message management unit 110 receives a special message transmitted through a last cell module among a plurality of cell modules connected in series or in parallel (referring to FIG. 7, a third special message received from a third cell module and the content of the third special message is described below).

The failure mode operation determination unit 120 determines whether to enter a failure mode by using at least one of the reception of the special message received from the message management unit 110 and a result of analyzing the special message.

When no message is received by the message management unit 110 within a timeout period, a timeout check section 121 finally determines whether to operate in the failure mode through a retry process.

A packet error code (PEC) check section 122 checks a packet error code of the received special message, and operates in the failure mode when it is determined that there is an error as a result of checking the packet error code. In such a case, when the error repeatedly occurs a preset number of times or more as a result of checking the packet error code, the PEC check section 122 finally determines to enter the failure mode.

A protocol check section 123 checks STX and ETX protocols and operates in the failure mode when it is determined that there is an error. In such a case, when the error repeatedly occurs a preset number of times or more as a result of checking the STX and ETX protocols, the protocol check section 123 finally determines to enter the failure mode.

A number-of-cell modules check section 124 receives and analyzes the messages received by the message management unit 110 to check the number of connected cell modules, checks whether cell module number data has been sequentially received to check whether the cell module number has been received in duplicate or missing, and operates in the failure mode when it is determined that there is an error. In such a case, when the error repeatedly occurs a preset number of times or more as a result of checking the number of modules, the number-of-cell modules check section 124 finally determines to enter the failure mode.

A preset number of times serving as a base for determining whether to enter the failure mode when an error occurs in receiving a special message within the timeout period, a preset number of times serving as a base for determining whether to enter the failure mode when an error occurs based on packet error code check, a preset number of times serving as a base for determining whether to enter the failure mode when an error occurs based on protocol check, and a preset number of times serving as a base for determining whether to enter the failure mode when an error occurs as a result of checking the number of cell modules may be set to the same value, or may be adjusted differently according to monitoring results.

In addition, the weight of a number counted when an error occurs for each determination criterion may be set differently, and the weight can also be changed by monitoring an error occurrence trend.

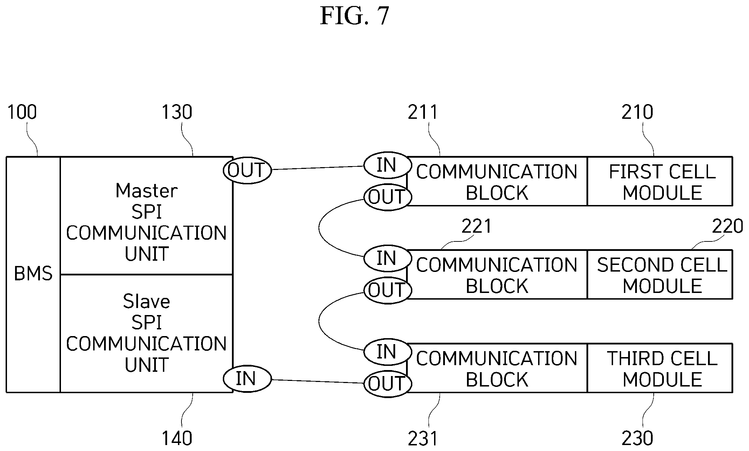

FIG. 6 illustrates a communication hardware configuration of a BMS and a cell module of the system for checking the number of modules according to an embodiment of the present disclosure, and FIG. 7 illustrates a special message transmission and reception process for automatically recognizing of the number of cell modules according to an embodiment of the present disclosure.

According to an embodiment of the present disclosure, hardware is configured so that a special message transmitted by a BMS 100 may be received through a last cell module. In addition, in order to secure the stability of a function of automatically recognizing the number of modules through software, a packet error code check, a STX and ETX protocol check, and a cell module number sequential reception check are performed in three stages for the special message, and when it is determined in each check result that an error has occurred, a retry (n^{th} Retry) is attempted for each stage.

The BMS 100 includes a Master SPI communication unit 130 and a Slave SPI communication unit 140.

Through the Master SPI communication unit 130, special messages that are one more than the maximum number of connectable cell modules are transmitted (OUT).

FIG. 7 illustrates an example in which three cell modules, that is, a first cell module 210, a second cell module 220, and a third cell module 230 are connected in order to help the understanding of those skilled in the art, and the number of cell modules is not limited to that illustrated in FIG. 7.

A communication block 211 of the first cell module 210 receives special messages from the Master SPI communication unit 130, and transmits first special messages to a communication block 221 of the second cell module 220.

The first special messages received by the communication block 221 of the second cell module 220 are remaining messages except for the last message among the special messages transmitted by the Master SPI communication unit 130.

The communication block 221 of the second cell module 220 receives the first special messages and transmits second special messages to a communication block 231 of the third cell module 230.

The second special messages received by the communication block 231 of the third cell module 230 are remaining messages except for the last message among the first special messages transmitted by the communication block 211 of the first cell module 210.

The Slave SPI communication unit 140 of the BMS 100 receives third special messages from the communication block 231 of the third cell module 230.

The third special messages received by the Slave SPI communication unit 140 of the BMS 100 are remaining messages except for the last message among the second special messages transmitted by the communication block 221 of the second cell module 220.

The special message, the first special message, the second special message, and the third special message each include a packet error code (PEC) in order to check data integrity due to a communication failure or a cell module abnormality.

In addition, each message includes the STX and ETX protocols and data, in which a cell module number is increased from 1, as data in the protocol in the order of transmission.

The third special messages received by the Slave SPI communication unit 140 of the BMS 100 are all remaining messages received (IN) from the last connected third cell module 230, and the BMS 100 analyzes the received message to check the number of connected cell modules.

The BMS 100 waits for the reception of the special message during the timeout period, and when no data is received within the timeout period, the BMS 100 operates in the failure mode through a retry process.

When the special messages are received, the BMS 100 primarily checks packet error codes of the received messages, and operates in the failure mode when it is determined that there is an error.

The BMS 100 secondarily checks the STX and ETX protocols, and operates in the failure mode when it is determined that there is an error.

The BMS 100 tertiarily checks whether cell module number data has been sequentially received to check whether the cell module number has been received in duplicate or missing, and operates in the failure mode when it is determined that there is an error.

In addition, in the primary, secondary, and tertiary check processes, the BMS 100 performs retry for a preset number of times before determining a final failure mode.

Referring to FIG. 7, the special message transmitted from the BMS 100 to the first cell module 210 is a special communication message that is one more than the maximum number (e.g. 16) of connectable cell modules.

The first special messages transmitted from the first cell module 210 to the second cell module 220 are the remaining messages transmitted except for the last message among the special messages.

The second special messages transmitted from the second cell module 220 to the third cell module 230 are the remaining messages transmitted except for the last message among the first special messages.

The third special messages transmitted from the third cell module 230 to the BMS 100 are the remaining message transmitted except for the last message among the second special messages.

The BMS 100 automatically recognizes the number 3 of actually connected cell modules by analyzing the received third special messages in a battery pack to which maximum 16 cell modules can be connected.

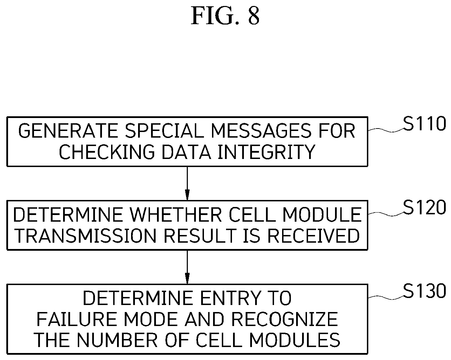

FIGS. 8, 9, and 10 illustrate a method for checking the number of modules according to an embodiment of the present disclosure.

Referring to FIG. 8, the method for checking the number of modules according to an embodiment of the present disclosure includes a step S110 of generating special messages for checking data integrity, a step S120 of determining whether a cell module transmission result is received, and a step S130 of determining an entry to a failure mode by analyzing the received special messages and automatically recognizing the number of cell modules.

In step S110, special messages to be transmitted from the BMS to the cell modules are generated, and special messages that are one more than the maximum number of cell modules are generated in consideration of the maximum number of cell modules connectable to the battery pack. The special message includes a packet error code, and each message including the STX and ETX protocols and data, in which a cell module number is sequentially increased from 1, is transmitted.

The cell modules transmit remaining messages, except for the last message among the received special messages, to the next cell modules connected in series or in parallel or the BMS.

In step S120, it is checked whether the special messages transmitted to the cell modules are received through a plurality of cell modules connected in series or in parallel.

In step S130, it is determined whether to enter the failure mode, by using at least one of whether the special messages have been received in step S120 and a result of analyzing the special messages when the special messages have been received, and when there is no error, the number of cell modules is automatically recognized and a main loop operation is performed.

In step S130, when it is checked that there is no message received within a timeout period in step S120, a retry process is performed to determine whether to finally operate in the failure mode. In such a case, when the retry process is repeated a first preset number of times or more, it is finally determined to enter the failure mode.

In step S130, the packet error code of the received special message is checked, and when it is determined that there is an error as a result of checking the packet error code, the BMS operates in the failure mode. In such a case, when the error repeatedly occurs a second preset number of times or more as a result of checking the packet error code, it is finally determined to enter the failure mode.

In step S130, when it is determined that there is an error by checking the STX and ETX protocols, the BMS operates in the failure mode. In such a case, when the error repeatedly occurs a third preset number of times or more as a result of checking the STX and ETX protocols.

In step S130, the number of connected cell modules is checked by analyzing the received messages, whether cell module number data has been sequentially received is checked to check whether a cell module number has been received in duplicate or missing, and when it is determined that there is an error, the BMS operates in the failure mode. In such a case, when the error repeatedly occurs a fourth preset number of times or more as a result of checking the number of cell modules, it is finally determined to enter the failure mode.

The first preset number of times to the fourth preset number of times described above may be set to the same value or may be adjusted differently according to monitoring results, and the weight of a number counted when an error occurs for each determination criterion may be set differently, and the weight can also be changed by monitoring an error occurrence trend.

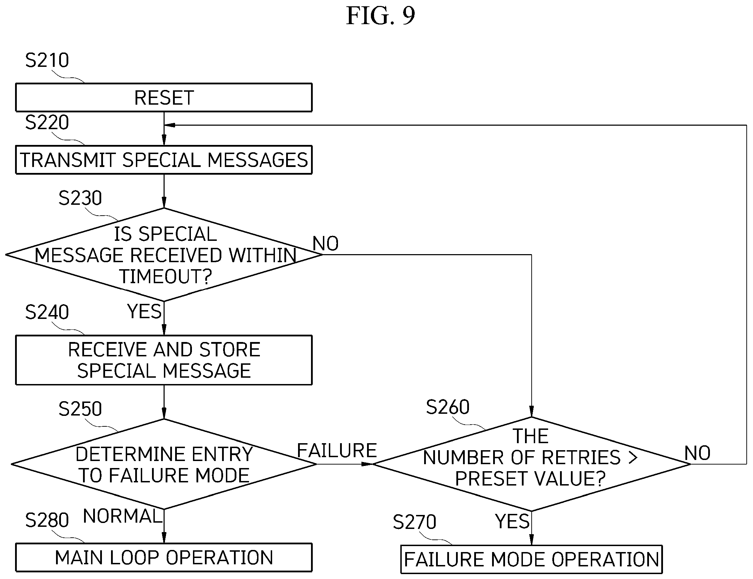

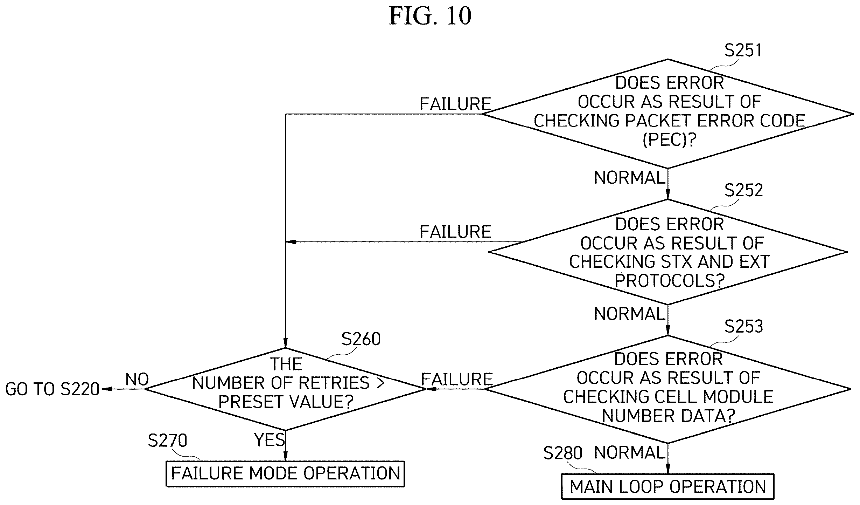

The specific process of the failure mode entry determination step is described below with reference to FIGS. 9 and 10.

Reset is performed (S210), and the Master SPI communication unit of the BMS transmits generated special messages (S220).

It is checked whether special messages are received from cell modules within a timeout (S230). When no special messages are received within the timeout, a retry is performed, and when it is checked that the number of retries exceeds a preset value (S260), the BMS operates in the failure mode (S270).

When the special message is received from the cell module within the timeout, that is, the last cell module among a plurality of cell modules connected in series or parallel, special messages are all stored in a buffer in order (S240).

It is determined to enter the failure mode by analyzing the special message (S250), and when it is determined that a failure has occurred, it is checked whether the number of retries exceeds the preset value (S260), and the BMS finally operates in the failure mode (S270).

When normality is checked by analyzing the special message, a main loop operation is performed (S280).

The failure mode entry determination process is described in more detail with reference to FIG. 10.

The packet error code of the received special message is checked to determine whether there is an error as a result of checking the packet error code (S251). When it is determined that there is an error, it is checked whether the number of retries exceeds the preset value (S260), and when the number of retries exceeds the preset value, the BMS operates in the failure mode (S270).

It is determined whether there is an error by checking the STX and ETX protocols of the received special message (S252). When it is determined that there is an error, it is checked whether the number of retries exceeds the preset value (S260), and when the number of retries exceeds the preset value, the BMS operates in the failure mode (S270).

The number of connected cell modules is checked by analyzing the received special message, and whether cell module number data has been sequentially received is checked to check whether a cell module number has been received in duplicate or missing (S253). When it is determined that there is an error, it is checked whether the number of retries exceeds the preset value (S260), and when the number of retries exceeds the preset value, the BMS operates in the failure mode (S270).

When a normal state with no error is checked as a result of checking the cell module number data, the main loop operation is performed (S280).

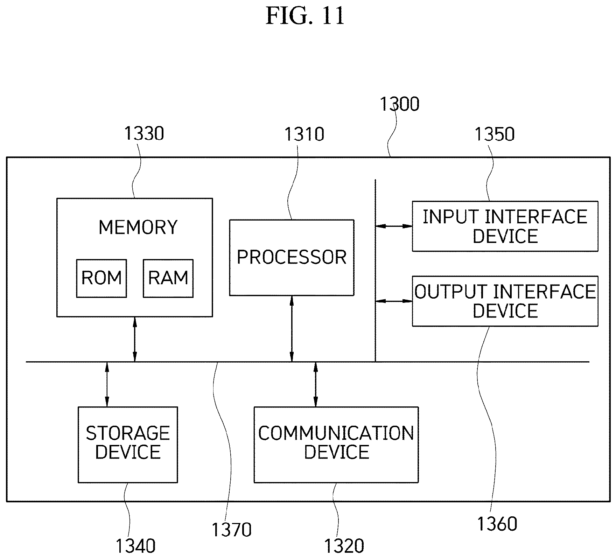

FIG. 11 is a block diagram illustrating a computer system for implementing the method according to an embodiment of the present disclosure.

Referring to FIG. 11, the computer system 1300 may include at least one of a processor 1310, a memory 1330, an input interface device 1350, an output interface device 1360, and a storage device 1340 communicating with one another through a bus 1370. The computer system 1300 may also include a communication device 1320 coupled to a network. The processor 1310 may be or include a central processing unit (CPU) or a semiconductor device that executes instructions stored in the memory 1330 or in the storage device 1340. The memory 1330 and the storage device 1340 may include various types of volatile or nonvolatile storage media. For example, the memory may include a read-only memory (ROM) and a random access memory (RAM). In example embodiments of the present disclosure, the memory may be located inside or outside the processor, and may be connected to the processor through various known means. The memory is or includes various types of volatile or nonvolatile storage media, and for example, may include a read-only memory (ROM) or a random access memory (RAM).

A battery monitoring device according to an embodiment of the present disclosure includes an input interface device 1350 that receives special messages received from cell modules, a memory 1330 that stores a program for automatically recognizing the number of cell modules by analyzing the special messages, and a processor 1310 that executes the program, and the processor 1310 determines whether to enter the failure mode by using at least one of whether the special messages are received within a preset time and a result of analyzing information of the special messages.

The processor 1310 determines whether to enter the failure mode when no special messages are received within the preset time, and when the special messages are received, the processor 1310 determines whether to enter the failure mode by using the result of analyzing information of the special messages to check a packet error code, check STX and ETX protocols, and check whether a cell module number has been received in duplicate or missing.

Accordingly, example embodiments of the present disclosure may be implemented as a method implemented in a computer or a non-transitory computer-readable medium storing computer-executable instructions. In an example embodiment, when executed by the processor, computer-readable instructions may perform a method according to at least one aspect of the present disclosure.

The communication device 1320 may transmit or receive wired signals or wireless signals.

Additionally, the method according to an example embodiment of the present disclosure may be implemented in the form of program instructions that can be executed through various computer means and recorded on a computer-readable medium.

The computer-readable medium may include program instructions, data files, data structures, etc., singly or in combination. The program instructions recorded on the computer-readable medium may be specially designed and configured for the example embodiments of the present disclosure, or may be known and usable by those skilled in the art of computer software. Computer-readable recording media may include a hardware device configured to store and perform program instructions. For example, the computer-readable recording media may be or include magnetic media such as hard disks, floppy disks, and magnetic tapes, optical media such as CD-ROMs and DVDs, magneto-optical media such as floptical disks, ROM, RAM, flash memory, etc. The program instructions may include not only machine language codes such as that generated by a compiler, but also high-level language codes that can be executed by a computer through an interpreter, etc.

Hereinafter, any material that may be usable for the secondary battery according to examples of the present disclosure will be described.

As the positive electrode active material, a compound capable of reversibly intercalating/deintercalating lithium (e.g., a lithiated intercalation compound) may be used. For example, at least one of a composite oxide of lithium and a metal such as at least one of cobalt, manganese, nickel, and combinations thereof may be used.

The composite oxide may be or include a lithium transition metal composite oxide, and examples thereof may include at least one of a lithium nickel-based oxide, a lithium cobalt-based oxide, a lithium manganese-based oxide, a lithium iron phosphate-based compound, a cobalt-free nickel-manganese-based oxide, or a combination thereof.

As an example, a compound represented by at least any one of the following formulas may be used: LiₐA_{1-b}X_{b}O_{2-c}D_{c} (0.90≤a≤1.8, 0≤b≤0.5, 0≤c≤0.05); LiₐMn_{2-b}X_{b}O_{4-c}D_{c} (0.90≤a≤1.8, 0≤b≤0.5, 0≤c≤0.05); LiₐNi_{1-b-c}Co_{b}X_{c}O_{2-α}D_{α} (0.90≤a≤1.8, 0≤b≤0.5, 0≤c≤0.5, 0<α<2); LiₐNi_{1-b-c}Mn_{b}X_{c}O_{2-α}D_{α} (0.90≤a≤1.8, 0≤b≤0.5, 0≤c≤0.5, 0<α<2); LiₐNi_{b}Co_{c}L¹_{d}GₑO₂ (0.90≤a≤1.8, 0≤b≤0.9, 0≤c≤0.5, 0≤d≤0.5, 0≤e≤0.1); LiₐNiG_{b}O₂ (0.90≤a≤1.8, 0.001≤b≤0.1); LiₐCoG_{b}O₂ (0.90≤a≤1.8, 0.001≤b≤0.1); LiₐMn_{1-b}G_{b}O₂ (0.90≤a≤1.8, 0.001≤b≤0.1); LiₐMn₂G_{b}O₄ (0.90≤a≤1.8, 0.001≤b≤0.1); LiₐMn_{1-g}G_{g}PO₄ (0.90≤a≤1.8, 0≤g≤0.5); Li_{(3-f)}Fe₂(PO₄)₃ (0≤f≤2); and LiₐFePO₄ (0.90≤a≤1.8).

In the above formulas: A is or includes at least Ni, Co, Mn, or a combination thereof; X is or includes at least Al, Ni, Co, Mn, Cr, Fe, Mg, Sr, V, a rare earth element, or a combination thereof; D is or includes at least O, F, S, P, or a combination thereof; G is or includes at least Al, Cr, Mn, Fe, Mg, La, Ce, Sr, V, or a combination thereof; and L1 is or includes at least Mn, Al, or a combination thereof.

A positive electrode for a lithium secondary battery may include a current collector and a positive electrode active material layer formed on the current collector. The positive electrode active material layer may include a positive electrode active material and may further include a binder and/or a conductive material.

The content of the positive electrode active material is in a range of about 90 wt% to about 99.5 wt% on the basis of 100 wt% of the positive electrode active material layer, and the content of the binder and the conductive material is in a range of about 0.5 wt% to about 5 wt%, respectively, on the basis of 100 wt% of the positive electrode active material layer.

The current collector may be or include aluminum (Al) but is not limited thereto.

The negative electrode active material may include a material capable of reversibly intercalating/deintercalating at least one of lithium ions, lithium metal, an alloy of lithium metal, a material capable of being doped and undoped with lithium, or a transition metal oxide.

The material capable of reversibly intercalating/deintercalating lithium ions may be or include a carbon-based negative electrode active material, which may include, for example, at least crystalline carbon, amorphous carbon, or a combination thereof. Examples of the crystalline carbon may include graphite, such as natural graphite or artificial graphite, and examples of the amorphous carbon may include at least one of soft carbon, hard carbon, a pitch carbide, a meso-phase pitch carbide, sintered coke, and the like.

A Si-based negative electrode active material or a Sn-based negative electrode active material may be used as the material capable of being doped and undoped with lithium. The Si-based negative electrode active material may be or include at least silicon, a silicon-carbon composite, SiOx (0 < x < 2), a Si-based alloy, or a combination thereof.

The silicon-carbon composite may be or include a composite of silicon and amorphous carbon. According to one example embodiment, the silicon-carbon composite may be in the form of a silicon particle and amorphous carbon coated on the surface of the silicon particle.

The silicon-carbon composite may further include crystalline carbon. For example, the silicon-carbon composite may include a core including crystalline carbon and silicon particle and an amorphous carbon coating layer on the surface of the core.

A negative electrode for a lithium secondary battery may include a current collector and a negative electrode active material layer disposed on the current collector. The negative electrode active material layer may include a negative electrode active material and may further include a binder and/or a conductive material.

For example, the negative electrode active material layer may include about 90 wt % to about 99 wt % of a negative electrode active material, about 0.5 wt % to about 5 wt % of a binder, and about 0 wt % to about 5 wt % of a conductive material.

A non-aqueous binder, an aqueous binder, a dry binder, or a combination thereof may be used as the binder. When an aqueous binder is used as the negative electrode binder, a cellulose-based compound capable of imparting viscosity may be further included.

As the negative electrode current collector, at least one of copper foil, nickel foil, stainless steel foil, titanium foil, nickel foam, copper foam, conductive metal-coated polymer substrate, and combinations thereof may be used.

An electrolyte for a lithium secondary battery may include a non-aqueous organic solvent and a lithium salt.

The non-aqueous organic solvent may constitute a medium through which ions involved in the electrochemical reaction of the battery can move.

The non-aqueous organic solvent may be or include at least a carbonate-based, an ester-based, an ether-based, a ketone-based, an alcohol-based solvent, an aprotic solvent, and may be used alone or in combination of two or more.

Depending on the type of lithium secondary battery, a separator may be present between the first electrode plate (e.g., the negative electrode) and the second electrode plate (e.g., the positive electrode). As the separator, at least polyethylene, polypropylene, polyvinylidene fluoride, or a multilayer film of two or more layers thereof may be used.

The separator may include a porous substrate and a coating layer including an organic material, an inorganic material, or a combination thereof on one or both surfaces of the porous substrate.

The organic material may include a polyvinylidene fluoride-based polymer or a (meth)acrylic polymer.

The inorganic material may include inorganic particles such as at least one of Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and combinations thereof but is not limited thereto.

The organic material and the inorganic material may be mixed in one coating layer or may be in the form of a coating layer containing an organic material and a coating layer containing an inorganic material that are laminated on each other.

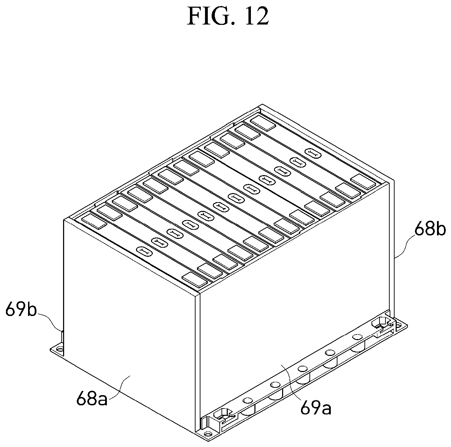

FIG. 12 is an illustration of a secondary battery module in which secondary batteries manufactured according to examples of the present disclosure are arranged. With the increase in secondary battery capacity for driving electric vehicles, and the like, a secondary battery module may be manufactured by arranging and connecting a plurality of secondary battery cells transversely and/or longitudinally. The plurality of secondary batteries may be arranged in a space defined by a pair of facing end plates 68a and 68b and a pair of facing side plates 69a and 69b. The secondary batteries may be designed appropriately in arrangement (direction) and number to obtain desired voltage and current specifications.

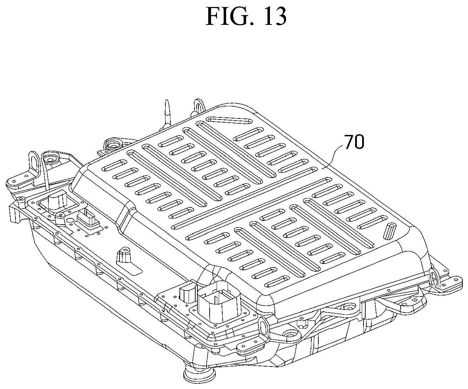

FIG. 13 is an illustration schematically showing the configuration of a battery pack 70 according to example embodiments of the present disclosure. Referring to FIG. 12, a battery pack 70 may include an assembly to which individual batteries are electrically connected, and a pack housing accommodating the same. In the drawings, for convenience of illustration, components including a bus bar, a cooling unit, external terminals for electrically connecting batteries, etc., are not shown.

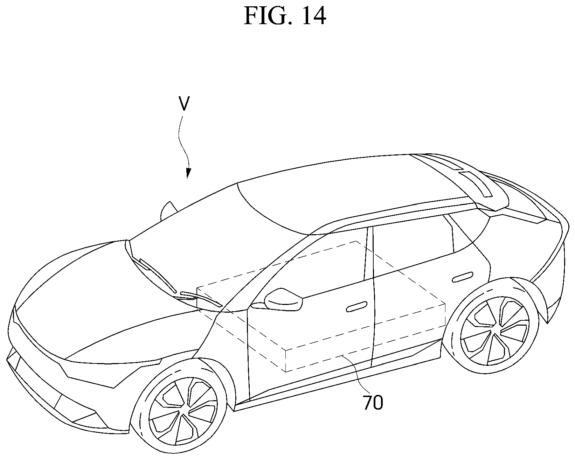

The battery pack 70 may be mounted on (or in) a vehicle. The vehicle may be, for example, an electric vehicle, a hybrid vehicle, a plug-in hybrid vehicle, and the like. The vehicle may be a four-wheeled vehicle or a two-wheeled vehicle but is not limited thereto. FIG. 14 shows a vehicle V which includes the battery pack 70 shown in FIG. 13 on the lower body thereof. The vehicle V may operate by (e.g., may be powered by) receiving power from the battery pack 70.

According to examples of the present disclosure, considering that the typically high investment cost per unit of a density meter makes it relatively costly when installed in various areas of a drying furnace, and installation thereof inside the drying furnace is difficult in terms of size, a difference in an ultrasonic transmission state due to a density difference depending on the drying status of an electrode plate may be monitored through an ultrasonic sensor, and the amount of drying heat inside the drying furnace may be controlled in real-time based on the monitoring results. Accordingly, when an electrode plate composition or a loading level is changed after a job change, or the surrounding air temperature is changed due to seasonal effects, and the like, it is possible to greatly reduce the trials and errors in a process of optimizing electrode plate drying conditions at the beginning of a process, minimize loss of the electrode plate, and improve the productivity of drying furnace equipment and the overall efficiency of an electrode plate drying process.

However, effects that can be achieved through the present disclosure are not limited to the above-described effects, and other technical effects not mentioned will be clearly understood by those skilled in the art from the description of the invention described below.

## Claims

1. A system (1300) for checking a number of cell modules (220, 230), the system (1300) comprising:
a message management unit (110) configured to generate special messages to be transmitted to a first cell module (210) among a plurality of cell modules (220, 230) connected in series or in parallel, and to receive special messages received from an n^{th} cell module; and
a failure mode operation determination unit configured to receive information on whether the special messages are received from the message management unit (110) and information on the special messages received from the n^{th} cell module, and wherein the failure mode operation determination unit is configured to determine an entry to a failure mode.

2. The system (1300) as claimed in claim 1, wherein the message management unit (110) is configured to
consider a maximum number of cell modules (220, 230) connectable to a battery pack (70),
generate special messages that are one more than the maximum number of cell modules (220, 230), and
transmit the generated special messages to the first cell module (210).

3. The system (1300) as claimed in claim 1 or 2, wherein the special message received from the n^{th} cell module comprises a result of transmitting remaining messages except for a last message among messages respectively received by the plurality of cell modules (220, 230) connected in series or in parallel.

4. The system (1300) as claimed in any one of the preceding claims, wherein the failure mode operation determination unit comprises a timeout check section (121), and when no message is received by the message management unit (110) within a timeout period, the timeout check section (121) is configured to determine whether to finally operate in the failure mode through a retry process.

5. The system (1300) as claimed in any one of the preceding claims, wherein the failure mode operation determination unit comprises a packet error code check section, and the packet error code check section is configured to check a packet error code of the received special message, and to determine an entry to the failure mode when it is determined that there is an error as a result of checking the packet error code.

6. The system (1300) as claimed in any one of the preceding claims, wherein the failure mode operation determination unit comprises a protocol check section (123), and the protocol check section (123) is configured to check STX and ETX protocols included in the special message, and to determine an entry to the failure mode when it is determined that there is an error.

7. The system (1300) as claimed in any one of the preceding claims, wherein the failure mode operation determination unit comprises a number-of-cell modules check section, and the number-of-cell modules check section is configured to check whether cell module number data has been sequentially received to check whether a cell module number has been received in duplicate or missing, and to determine an entry to the failure mode when it is determined that there is an error.

8. A method for checking the number of modules performed by a system (1300) for checking the number of modules, the method comprising:
(a) generating special messages for checking data integrity;
(b) determining whether a cell module transmission result is received; and
(c) determining an entry to a failure mode by analyzing the received special messages and automatically recognizing the number of cell modules (220, 230).

9. The method as claimed in claim 8, wherein in (a), a special message to be transmitted from a battery management system, BMS, (100) to a cell module (220, 230) is generated, and more special messages than a maximum number of cell modules (220, 230) by a preset number are generated in consideration of a maximum number of cell modules (220, 230) connectable to a battery pack (70).

10. The method as claimed in claim 9, wherein the preset number is 1.

11. The method as claimed in any one of the claims 8 to 10, wherein the special message comprises a packet error code, and each message comprises STX and ETX protocols and data in which a cell module number is sequentially increased from 1.

12. The method as claimed in any one of the claims 11 to 10, wherein in (b), it is checked whether special messages to be transmitted to the cell modules (220, 230) are received through a plurality of cell modules (220, 230) connected in series or in parallel.

13. The method as claimed in claim 12, wherein in (c), it is determined whether to enter the failure mode, by using at least one of whether the special messages have been received and a result of analyzing the special messages.

14. The method as claimed in claim 13, wherein in (c), when there is no error, the number of cell modules (220, 230) is automatically recognized and a main loop operation is performed.

15. An apparatus for checking the number of modules, the apparatus comprising:
an input interface device (1350) configured to receive special messages received from cell modules (220, 230);
a memory (1330) configured to store a program for automatically recognizing the number of cell modules (220, 230) by analyzing the special messages; and
a processor (1310) that executes the program,
wherein the processor (1310) is configured to determine whether to enter a failure mode by using at least one of whether the special messages are received within a preset time and a result of analyzing information of the special messages.
